(19) Europäisches Patentamt / European Patent Office / Office européen des brevets

(11) **EP 1 782 536 B1**

(12) **FASCICULE DE BREVET EUROPEEN**

(45) Date de publication et mention
de la délivrance du brevet:
**31.12.2008 Bulletin 2009/01**

(51) Int Cl.:
***H03M 1/10*** *(2006.01)*

(21) Numéro de dépôt: **04819697.6**

(86) Numéro de dépôt international:
**PCT/EP2004/053172**

(22) Date de dépôt: **30.11.2004**

(87) Numéro de publication internationale:
**WO 2005/055430 (16.06.2005 Gazette 2005/24)**

(54) **PROCEDE DE GENERATION D'UN SIGNAL NUMERIQUE REPRESENTATIF DES ERREURS D'APPARIEMENT D'UN SYSTEME DE CONVERSION ANALOGIQUE NUMERIQUE A ENTRELACEMENT TEMPOREL, ET UN CONVERTISSEUR ANALOGIQUE NUMERIQUE A ENTRELACEMENT TEMPOREL L'UTILISANT**

VERFAHREN ZUM ERZEUGEN EINES DIGITALSIGNALS, DAS ANPASSUNGSFEHLER IN EINEM ANALOG/DIGITAL-UMSETZUNGSSYSTEM MIT ZEITVERSCHACHTELUNG REPRÄSENTIERT UND ANALOG/DIGITAL-UMSETZER MIT ZEITVERSCHACHTELUNG DAMIT

METHOD OF GENERATING A DIGITAL SIGNAL THAT IS REPRESENTATIVE OF MATCH ERRORS IN AN ANALOGUE-TO-DIGITAL CONVERSION SYSTEM WITH TIME INTERLEAVING, AND AN ANALOGUE-TO-DIGITAL CONVERTER WITH TIME INTERLEAVING USING SAME

(84) Etats contractants désignés:
**AT BE BG CH CY CZ DE DK EE ES FI FR GB GR HU IE IS IT LI LU MC NL PL PT RO SE SI SK TR**

(30) Priorité: **05.12.2003 FR 0314309**

(43) Date de publication de la demande:
**09.05.2007 Bulletin 2007/19**

(73) Titulaire: **THALES**
**92200 Neuilly sur Seine (FR)**

(72) Inventeur: **GREMILLET, Patrick**
**94117 Arcueil (FR)**

(74) Mandataire: **Lucas, Laurent Jacques**
**Marks & Clerk France**
**Conseils en Propriété Industrielle**
**Immeuble " Visium "**
**22, avenue Aristide Briand**
**94117 Arcueil Cedex (FR)**

(56) Documents cités:
- HUMMELS D M ET AL: "Distortion compensation for time-interleaved analog to digital converters" INSTRUMENTATION AND MEASUREMENT TECHNOLOGY CONFERENCE, 1996. IMTC-96. CONFERENCE PROCEEEDINGS. QUALITY MEASUREMENTS: THE INDISPENSABLE BRIDGE BETWEEN THEORY AND REALITY., IEEE BRUSSELS, BELGIUM 4-6 JUNE 1996, NEW YORK, NY, USA,IEEE, US, 4 juin 1996 (1996-06-04), pages 728-731, XP010163973 ISBN: 0-7803-3312-8
- PATENT ABSTRACTS OF JAPAN vol. 018, no. 467 (E-1599), 30 août 1994 (1994-08-30) & JP 06 152410 A (ADVANTEST CORP), 31 mai 1994 (1994-05-31)

EP 1 782 536 B1

**Description**

L'invention concerne un procédé de génération d'un signal numérique représentatif de l'erreur d'appariement entre les canaux d'un système de conversion analogique numérique à entrelacement temporel, un procédé de suppression des erreurs ainsi calculées et un système de conversion analogique numérique à entrelacement temporel l'utilisant.

Les deux principales caractéristiques d'un convertisseur analogique numérique sont, bien entendu, sa résolution en bits et sa fréquence d'échantillonnage.

Afin d'augmenter la vitesse des convertisseurs analogique numérique, une solution classique consiste à utiliser plusieurs canaux de conversion en parallèle commandés séquentiellement, à partir d'une horloge principale divisée et décalée.

Ces systèmes de conversion analogique numérique à entrelacement temporel présentent cependant des erreurs liées à l'appariement imparfait entre les canaux. Notamment, ces erreurs peuvent résulter des décalages de tension, des différences de gain, des différences de réponse en fréquence ou en phase, et des écarts dans les instants d'échantillonnage des différents canaux.

Afin de préserver l'intérêt d'une telle structure, la minimisation des erreurs d'appariement des canaux est indispensable. Cette minimisation peut être effectuée soit en réduisant (a priori) autant que possible les différences entre les canaux, soit en corrigeant (a posteriori) le signal numérisé.

Un certain nombre de techniques peuvent être employées pour minimiser les erreurs d'appariement entre les canaux des systèmes de conversion analogique numérique à entrelacement temporel.

Le brevet américain US 4,633,226 de Black, Jr. délivré le 30 décembre 1986 propose de mettre en commun un certain nombre d'éléments entre les canaux afin de diminuer le nombre d'éléments non appariés. Ce type de solution suppose la modification des convertisseurs analogique numérique utilisés dans chaque canal, ce qui n'est pas toujours possible.

Une autre solution, classiquement utilisée, s'attaque à la source des erreurs d'appariement des canaux. Notamment, elle propose l'ajustement de la phase des horloges d'échantillonnage (comme dans le brevet américain US 4,763,105 de Jenq délivré le 9 août 1988), des tensions de décalage, des différences de gain de chaque canal. Cette solution suppose un ajustement de chaque paramètre concerné pour chaque canal. Cela conduit donc à des réalisations complexes. De plus ces ajustements, notamment dans le cas de la phase des horloges d'échantillonnage, sont des sources de bruit supplémentaires. Cette solution peut donc conduire à dégrader les performances dynamiques du système de conversion analogique numérique à entrelacement temporel.

Le traitement du signal peut aussi permettre la correction des erreurs d'appariement, notamment par l'utilisation de filtres égaliseurs numériques. Les égaliseurs peuvent utiliser, pour ce faire, la différence de réponse des canaux par rapport à un canal pris comme référence tel que l'indique, par exemple, le brevet américain US 5,239,299 de Apple et al. délivré le 24 août 1993. Ce type de solution corrige, après conversion numérique, les effets des erreurs d'appariement des canaux. La correction dépend de la qualité des filtres utilisés. La correction ne peut donc pas être idéale sur la totalité du spectre sauf à utiliser une quantité rédhibitoire de matériel.

Ces techniques visent donc soit à agir à la source, à savoir sur les différences (analogiques) entre les canaux de conversion ; soit à agir sur le signal numérisé, en traitant les effets des défauts qui se sont agrégés au signal échantillonné. Dans ce dernier cas, l'opération est donc double puisqu'il s'agit d'abord d'extraire les défauts du signal à la sortie du convertisseur puis, ensuite, de les éliminer.

La présente invention permet de pallier ou, pour le moins, de réduire ces inconvénients en corrigeant les erreurs d'appariement entre les canaux des systèmes de conversion analogique numérique à entrelacement temporel par la création directe de signaux numériques représentatifs de ces erreurs, et leur soustraction du signal numérisé en sortie du système de conversion.

Il peut être considéré que le document IEEE intitulé « Distortion compensation for time-interleaved analog to digital converters », publié en 1996 par Hummel D.M. et al, constitue l'état de la technique le plus proche.

Un objet de l'invention est un procédé de génération d'un signal numérique représentatif de l'erreur d'appariement entre les canaux d'un système de conversion analogique numérique à entrelacement temporel et est défini dans la revendication 1.

La solution proposée outre l'avantage d'être numérique est moins complexe car elle ne nécessite pas l'extraction des défauts du signal à la sortie du convertisseur.

L'invention a aussi pour objet un dispositif de conversion analogique numérique à entrelacement temporel de fréquence d'échantillonnage Fs selon la revendication 9.

Les caractéristiques et avantages de l'invention apparaîtront plus clairement à la lecture de la description, faite à titre d'exemple, et des figures s'y rapportant qui représentent :

- Figure 1, un schéma bloc illustrant le principe du système de conversion analogique numérique à entrelacement temporel, selon l'art antérieur,

- Figure 2, un diagramme des différentes horloges d'échantillonnage du système de conversion analogique numérique à entrelacement temporel, selon l'art antérieur,
- Figure 3, un diagramme du spectre du signal échantillonné obtenu en sortie du système de conversion analogique numérique à entrelacement temporel, selon l'art antérieur,
- Figure 4, un schéma bloc illustrant le principe de correction fréquentielle des erreurs d'appariement d'un système de conversion analogique numérique à entrelacement temporel, selon l'invention,
- Figure 5, un exemple de réalisation de la détermination des informations de calibration IC à partir de la réponse fréquentielle du système de conversion analogique numérique à entrelacement temporel, selon l'invention,
- Figure 6, un diagramme du spectre du signal en sortie du dispositif de génération de signaux « peigne » figurant dans les moyens de génération du signal représentatif des erreurs d'appariement, selon l'invention,
- Figure 7, un schéma bloc d'un exemple de moyens de calcul des informations de calibration, selon l'invention,
- Figure 8, un diagramme du spectre du signal en sortie du dispositif de modulation d'amplitude figurant dans les moyens de génération du signal représentatif des erreurs d'appariement, selon l'invention,
- Figure 9, un schéma bloc du dispositif de modulation d'amplitude figurant dans les moyens de génération du signal représentatif des erreurs d'appariement, selon l'invention,
- Figure 10, un diagramme du spectre du signal numérisé après soustraction du signal obtenu par les moyens de génération du signal représentatif des erreurs d'appariement, selon l'invention.

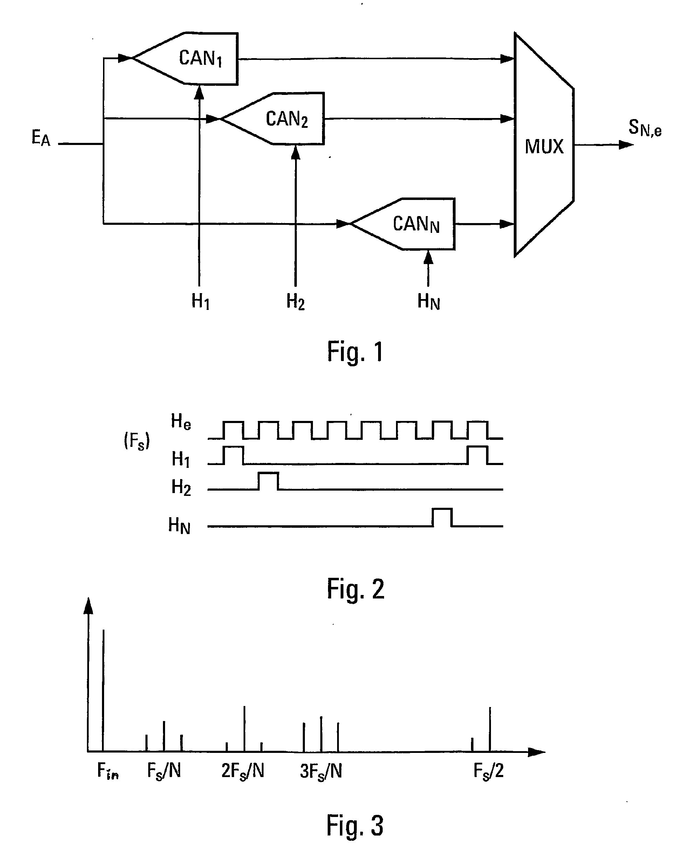

La figure 1 illustre un système de conversion analogique numérique à entrelacement temporel. Le système de conversion analogique numérique à entrelacement temporel comporte N canaux. Chaque canal n comporte un convertisseur analogique numérique $CAN_i$ piloté par une horloge $H_i$.

Comme l'illustre la figure 2, lorsque l'horloge d'échantillonnage $H_e$ du système de conversion analogique numérique à entrelacement temporel a une fréquence Fs, chacune des horloges $H_i$ a une fréquence Fs/N. En outre, l'horloge $H_i$ est décalée de l'horloge $H_{i-1}$ du canal voisin d'une période 1/Fs.

Le signal d'entrée analogique $E_A$ est donc échantillonné sur chacun des canaux à la fréquence Fs/N à un instant décalé de 1/Fs par rapport au canal voisin. Les signaux échantillonnés en sortie des convertisseurs analogiques numériques $CAN_i$ sont ensuite multiplexés par le multiplexeur MUX pour obtenir le signal numérique $e(nT_s)$ échantillonné à la fréquence Fs.

La mise en parallèle de plusieurs canaux de conversion commandés séquentiellement, à partir d'une horloge principale divisée et décalée est une solution classique pour l'augmentation de la vitesse des convertisseurs analogique numérique.

Ces systèmes de conversion analogique numérique à entrelacement temporel présentent cependant des erreurs liées à l'appariement imparfait entre les canaux. Dans les systèmes de conversion analogique numérique à entrelacement temporel, tels que celui illustré par la figure 1, les défauts d'appariement des différents canaux sont sources d'erreurs.

Les défauts d'appariement entre les différents canaux du système de conversion analogique numérique à entrelacement temporel apparaissent dans le spectre du signal échantillonné sous forme de spectres parasites autour des fréquences k.Fs/N, comme le montre la figure 3. Fs est la fréquence de l'horloge d'échantillonnage et N le nombre de canaux du système de conversion analogique numérique à entrelacement temporel. Le spectre du signal échantillonné de la figure 3 est celui obtenu pour un signal d'entrée sinusoïdal de fréquence $F_{in}$.

Ces appariements concernent :

Les tensions de décalage (offset) : l'erreur va alors se traduire par l'apparition de raies aux fréquences fixes k.Fs/N d'amplitude liée à la tension de décalage entre les canaux.

Le gain : l'erreur va alors se traduire par l'apparition de spectres autour des fréquences kFs/N d'amplitude liée à l'écart de gain entre les canaux. Ce phénomène est assimilable à une modulation en amplitude.

La phase ou le timing : l'erreur va alors se traduire par l'apparition de spectres autour des fréquence kFs/N, d'amplitude liée à l'écart temporel de l'horloge d'échantillonnage entre les canaux. Ce phénomène est assimilable à une modulation de fréquence.

La bande passante : l'erreur va alors se traduire par un gain et une phase différente sur le signal d'entrée d'où une combinaison des deux erreurs précédentes.

L'invention consiste en un procédé permettant, par modulation numérique de signaux de fréquence k.Fs/N à l'aide d'informations obtenues par calibration, de créer des signaux de phase et d'amplitude voisins de ceux des défauts, et à les soustraire du signal numérisé.

Les principaux avantages de ce procédé de suppression des erreurs d'appariement sont :

- la correction par traitement numérique du signal échantillonné ;
- le traitement direct des erreurs induites par l'entrelacement.

D'où une double simplification du traitement : pas de nécessité d'extraire l'erreur du signal utile et un moindre besoin de précision dans les calculs.

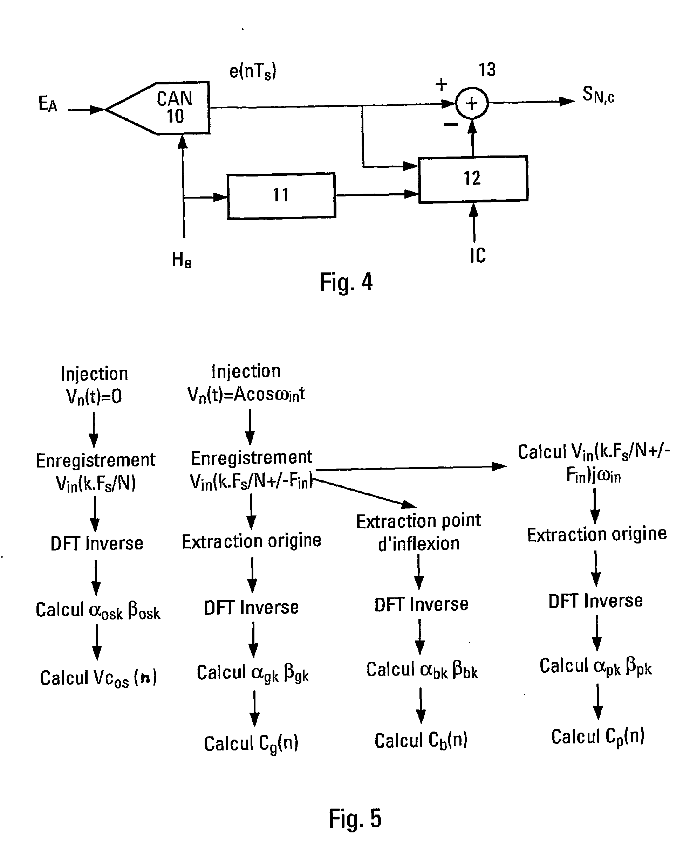

La figure 4 montre un exemple de mise en oeuvre du procédé de suppression selon l'invention permettant ainsi d'annuler ou de diminuer les défauts d'appariement.

Dans un premier temps, le spectre du signal numérique représentatif des défauts d'appariement est déterminé en fonction de la réponse fréquentielle du système de conversion analogique numérique à entrelacement temporel à au moins un signal de calibration. Le signal de calibration est constitué par un signal analogique connu. Ainsi, lors de cette étape aussi appelée « phase de calibration », des signaux analogiques connus sont injectés dans le système de conversion analogique numérique à entrelacement temporel. Sont alors déterminées les amplitudes et des phases des différentes raies parasites. A partir de cette réponse fréquentielle, des informations de calibration IC comportant, notamment, la valeur des différentes tensions de décalage et/ou les écarts de gain et/ou de phase... entre les canaux peuvent être déterminées.

En analysant le spectre du signal échantillonné, des informations de calibration IC peuvent être déterminées. En effet, le signal échantillonné s(n) en sortie du système de conversion analogique numérique à entrelacement temporel est un signal périodique discret de période N $x_N(n)$ pouvant s'écrire sous forme d'une série de Fourier :

$$x_N(n) = \sum_{l=0}^{N-1} C_l e^{j2\pi\frac{\ell}{N}n} \text{ avec } C_l = \frac{1}{N}\sum_{k=0}^{N-1} x_N(k)e^{-j2\pi\frac{\ell}{N}k}$$

$$x_N(n) = \sum_{l=0}^{N-1}\sum_{k=0}^{N-1}\frac{1}{N}x_N(k)e^{j2\pi\frac{\ell}{N}(n-k)} = \sum_{l=0}^{N-1}\frac{1}{N}e^{j2\pi\frac{\ell}{N}n}\sum_{k=0}^{N-1}x_N(k)e^{-j2\pi\frac{\ell}{N}k}$$

Si l'entrée e(t) du système de conversion analogique numérique à entrelacement temporel est un signal quelconque, le signal échantillonné est un signal $e_1(t)$ où $e_1$ est le résultat de l'influence de la bande passante limitée à $\omega_0$ sur e.

La sortie du système de conversion analogique numérique à entrelacement temporel à N canaux est alors la suivante :

$$\begin{aligned} s(n) &= \Delta V_k + (1+\Delta G_k)e_{1k}(nT_s + \Delta t_k) \\ &= \Delta V_k + e_{1k}(nT_s + \Delta t_k) + \Delta G_k e_{1k}(nT_s + \Delta t_k) \end{aligned} \text{ avec } k \equiv n[N]$$

en notant :

$\Delta V_k$ la tension de décalage du canal k

$\Delta G_k$ l'erreur de gain en amplitude du canal k (le gain est normalisé à 1)

$\Delta t_k$ l'écart temporel du canal k

$\Delta\omega_k$ l'écart de bande passante du canal k (par rapport à une bande passante nominale à -3dB $\omega_0$)

$T_s$ la période de l'horloge d'échantillonnage

$e_{1k}$ le résultat de l'influence de la bande passante limitée à $\omega_0+\Delta\omega_k$ sur e.

En général l'écart temporel est très petit devant la période d'échantillonnage, l'écart de gain très petit devant 1, l'écart de bande passante très petit devant la bande passante. La sortie du système de conversion analogique numérique à entrelacement temporel à N canaux peut donc être approximée au premier ordre :

$$s(n) = e_{1k}(nT_s) + \Delta V_k + \frac{de_1}{dt}(nT_s)\Delta t_k + e_{1k}(nT_s)\Delta G_k + \frac{de_1}{d\omega_0}(nT_s)\Delta\omega_k \text{ avec } k \equiv n[N]$$

Si l'influence de la bande passante limitée à $\omega_0$ est considérée comme due à un système du premier ordre, la transformée de Laplace de $e_1(t)$ est $E_1(p) = \dfrac{\omega_0}{p + \omega_0} E(p)$, et donc la sensibilité de variation de $\omega_0$ est :

$$\frac{dE_1}{d\omega_0}(p) = \frac{p}{(p+\omega_0)^2} E(p) = \frac{1}{\omega_0} \frac{p}{p+\omega_0} E(p) = \frac{1}{\omega_0} E_2(p)$$ en notant $e_2(t)$ le résultat du filtrage de $e_1(t)$ par le filtre passe haut de réponse $p/(p+\omega_0)$.

En utilisant l'écriture sous forme de série de Fourier, l'erreur sur la sortie du système de conversion analogique numérique à entrelacement temporel à N canaux $\Delta s(n) = s(n) - e(nT_s)$ peut donc s'écrire :

$$\Delta s(n) = \sum_{l=0}^{N-1} e^{j2\pi\frac{\ell}{N}n} \left[ \begin{array}{l} \dfrac{1}{N}\sum_{k=0}^{N-1}\Delta V_k e^{-j2\pi\frac{\ell}{N}k} + e_1(nT_s)\dfrac{1}{N}\sum_{k=0}^{N-1}\Delta G_k e^{-j2\pi\frac{\ell}{N}k} + \\[2mm] \dfrac{de_1}{dt}(nT_s)\dfrac{1}{N}\sum_{k=0}^{N-1}\Delta t_k e^{-j2\pi\frac{\ell}{N}k} + e_2(nT_s)\dfrac{1}{N}\sum_{k=0}^{N-1}\dfrac{\Delta\omega_k}{\omega_0}e^{-j2\pi\frac{\ell}{N}k} \end{array} \right]$$

Le spectre de l'erreur est donc :

$$F(\Delta s(\omega))$$

$$= \sum_{l=-\infty}^{+\infty} e^{j\omega n T_s} \sum_{l=0}^{N-1} e^{j2\pi\frac{l}{N}n} \left[ \begin{array}{l} \dfrac{1}{N}\sum_{k=0}^{N-1}\Delta V_k e^{-j2\pi\frac{l}{N}k} + e_1(nT_s)\dfrac{1}{N}\sum_{k=0}^{N-1}\Delta G_k e^{-j2\pi\frac{l}{N}k} + \\[2mm] \dfrac{de_1}{dt}(nT_s)\dfrac{1}{N}\sum_{k=0}^{N-1}\Delta t_k e^{-j2\pi\frac{l}{N}k} + \\[2mm] e_2(nT_s)\dfrac{1}{N}\sum_{k=0}^{N-1}\dfrac{\Delta\omega_k}{\omega_0}e^{-j2\pi\frac{l}{N}k} \end{array} \right]$$

$$= \left[ \begin{array}{l} \dfrac{1}{N}\sum_{l=0}^{N-1}1(\omega - l\dfrac{\omega_s}{N})F(\Delta V(l)) + \dfrac{1}{N}\sum_{l=0}^{N-1}F(e_1(\omega - l\dfrac{\omega_s}{N}))F(\Delta G(l)) + \\[2mm] \dfrac{1}{N}\sum_{l=0}^{N-1}F(\dfrac{de_1}{dt}(\omega - l\dfrac{\omega_s}{N}))F(\Delta t(l)) + \dfrac{1}{N}\sum_{l=0}^{N-1}F(H(e_1(\omega - l\dfrac{\omega_s}{N})))\dfrac{F(\Delta\omega(l))}{\omega_0} \end{array} \right]$$

avec les notations suivantes :

$1(\omega)$ est un signal qui vaut 1 pour $\omega = 0$ et 0 ailleurs
$F(e_1)$ est la transformée de Fourier de $e_1(t)$
$F(de_1/dt)$ est la transformée de Fourier de $de_1/dt$
$F(\Delta V)$ est la transformée de Fourier (discrète) du vecteur $\Delta V_k$
$F(\Delta G)$ est la transformée de Fourier (discrète) du vecteur $\Delta G_k$
$F(\Delta t)$ est la transformée de Fourier (discrète) du vecteur $\Delta t_k$
$F(\Delta\omega)$ est la transformée de Fourier (discrète) du vecteur $\Delta\omega_k$
$H$ est la réponse fréquentielle du filtre passe haut $p/(p+\omega_0)$.

$$\omega_s = 2\pi/T_s$$

Il apparaît donc des spectres parasites :

- des raies relatives aux tensions de décalage, aux fréquence multiples de F$_s$/N avec une valeur égale à

$$\frac{1}{N}F(\Delta V(l)) \; ;$$

- des spectres relatifs aux erreurs de gain, comportant le spectre de e$_1$(t) transposé autour des fréquences multiples de F$_s$/N, avec une valeur égale à $\dfrac{1}{N}F(e_1(\omega))F(\Delta G(l)) \; ;$

- des spectres relatifs aux erreurs de phase, comportant le spectre de de$_1$/dt(t) transposé autour des fréquences multiples de F$_s$/N, avec une valeur égale à $\dfrac{1}{N}F(\dfrac{de_1}{dt}(\omega))F(\Delta t(l)) \; ;$

- des spectres relatifs aux erreurs de bande passante, comportant le résultat du filtrage de e$_1$(t) par le passe haut p/ (p+$\omega_0$), transposé autour des fréquences multiples de F$_s$/N, avec une valeur égale à

$$\frac{1}{N}F(H(e_1(\omega)))F(\Delta\omega(l)) \,.$$

Le signal numérique représentatif des erreurs d'appariement comporte donc :

- des raies de fréquence $f_{os} = \dfrac{F_s}{N}, l = 0,1,\cdots,N-1$ avec une amplitude $A_{os} = \dfrac{1}{N}\sum_{k=0}^{N-1}\Delta V_k e^{-j2\pi\frac{l}{N}k}$ , correspondant à un signal représentatif des erreurs de décalage $Vc_{os}(n) = \dfrac{1}{N}\sum_{l=0}^{N-1}\sum_{k=0}^{N-1}\Delta V_k e^{j2\pi\frac{l}{N}(n-k)} \; ;$

- des spectres autour des fréquences $f_{os} = \dfrac{F_s}{N}, l = 0,1,\cdots,N-1$ obtenus par modulation d'amplitude par le signal d'entrée de raies d'amplitude $A_g = \dfrac{1}{N}\sum_{k=0}^{N-1}\Delta G_k e^{-j2\pi\frac{l}{N}k}$ , correspondant à un signal représentatif des erreurs de gain $Vc_g(n) = \dfrac{1}{N}e_1(nT_S)\sum_{l=0}^{N-1}\sum_{k=0}^{N-1}\Delta G_k e^{j2\pi\frac{l}{N}(n-k)} = e_1(nT_S).C_g(n) \; ;$

- des spectres autour des fréquences $f_{os} = \dfrac{F_s}{N}, l = 0,1,\cdots,N-1$ obtenus par modulation d'amplitude par la dérivée du signal d'entrée de raies d'amplitude $A_p = \dfrac{1}{N}\sum_{k=0}^{N-1}\Delta t_k e^{-j2\pi\frac{l}{N}k}$ , correspondant à un signal représentatif des erreurs de phase $Vc_p(n) = \dfrac{1}{N}\dfrac{de_1}{dt}(nT_S)\sum_{l=0}^{N-1}\sum_{k=0}^{N-1}\Delta t_k e^{j2\pi\frac{l}{N}(n-k)} = \dfrac{de_1}{dt}(nT_S).C_p(n) \; ;$

- des spectres autour des fréquences $f_{os} = \dfrac{F_s}{N}, l = 0,1,\cdots,N-1$ obtenus par modulation d'amplitude par le résultat du filtrage passe haut p/(p+$\omega_0$) du signal e$_1$(t) de raies d'amplitude $A_b = \dfrac{1}{N}\sum_{k=0}^{N-1}\dfrac{\Delta\omega_k}{\omega_0}e^{-j2\pi\frac{l}{N}k}$ , correspondant à un signal représentatif des erreurs de bande passante

$$Vc_b(n) = \frac{1}{N} e_2(nT_S) \sum_{l=0}^{N-1} \sum_{k=0}^{N-1} \frac{\Delta\omega_k}{\omega_0} e^{j2\pi\frac{l}{N}(n-k)} = e_2(nT_S).C_b(n).$$

La phase de calibration comporte donc l'injection en entrée du système de conversion analogique numérique à entrelacement temporel de signaux analogiques de fréquence et d'amplitude connues (notamment des sinusoïdes pures) comme le montre l'exemple du procédé de calibration illustré par la figure 5.

L'analyse du spectre du signal échantillonné en sortie du système de conversion analogique numérique à entrelacement temporel est facilitée par le fait que :

- les raies parasites relatives aux tensions de décalage sont proportionnelles à la transformée de Fourier discrète du vecteur $\Delta V_k$;
- les raies parasites relatives aux erreurs de gain sont proportionnelles à la transformée de Fourier discrète du vecteur $\Delta G_k$;
- les raies parasites relatives aux erreurs de phase sont proportionnelles à la transformée de Fourier discrète du vecteur $\Delta t_k$;
- les raies parasites relatives aux erreurs de bande passante sont proportionnelles à la transformée de Fourier discrète du vecteur $\Delta\omega_k/\omega_0$.
- les composantes des vecteurs $\Delta V_k$, $\Delta G_k$, $\Delta t_k$, $\Delta\omega_k$ peuvent donc être extraites des spectres des signaux échantillonnés par transformée de Fourier discrète inverse.

Dans un premier temps un signal $V_n(t) = 0$ est injecté, le signal échantillonné en sortie du convertisseur analogique numérique est enregistré, son spectre calculé par transformée de Fourier. Des valeurs à $kF_s/N$ sont extraites par transformée de Fourier discrète inverse des coefficients $\alpha_{osk}$, $\beta_{osk}$ à partir desquels le signal $Vc_{os}(n)$ représentatif des erreurs de tension de décalage est calculé.

Dans un deuxième temps des signaux $V_n(t) = A\cos\omega_{in}(t)$ avec plusieurs valeurs de $\omega_{in}$ sont injectés, les signaux échantillonnés en sortie du convertisseur analogique numérique sont enregistrés, leur spectre calculé par transformée de Fourier. Les valeurs $kF_s/N \pm F_{in}$ à sont ensuite extraites en fonction de $\omega_{in}$.

Des points d'origine sont extraits par transformée de Fourier discrète inverse des coefficients $\alpha_{gk}$, $\beta_{gk}$ à partir desquels le coefficient $C_g(n)$ multiplicateur du signal d'entrée permettant de générer le signal représentatif des erreurs de gain est calculé.

Des points d'inflexion sont extraits par transformée de Fourier discrète inverse des coefficients $\alpha_{bk}$, $\beta_{bk}$ à partir desquels le coefficient $C_b(n)$ multiplicateur du signal d'entrée permettant de générer le signal représentatif des erreurs de bande passante est calculé.

A partir des mêmes signaux échantillonnés sont extraites les courbes $V_n(kF_s/N+/-F_{in})/j\omega_{in}$ en fonction de $\omega_{in}$. Des points d'origine sont extraites par transformée de Fourier discrète inverse les informations des coefficients $\alpha_{pk}$, $\beta_{pk}$ à partir desquels le coefficient $C_p(n)$ multiplicateur du signal d'entrée permettant de générer le signal représentatif des erreurs de phase est calculé.

L'ensemble des signaux $Vc_{os}$ et coefficients $C_g(n)$, $C_b(n)$ et $C_p(n)$ ainsi déterminés constituent des informations de calibration IC.

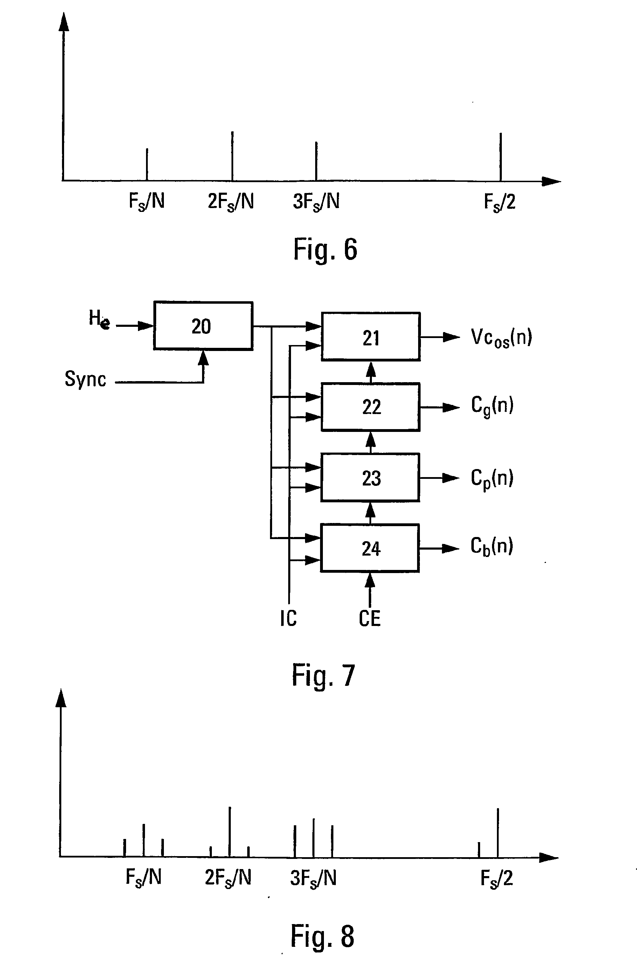

Dans un deuxième temps, nommé par la suite phase opérationnelle, i.e. phase durant laquelle des signaux quelconques sont échantillonnés par le système de conversion analogique numérique à entrelacement temporel est généré un signal numérique représentatif des erreurs d'appariement des canaux. Par exemple, ledit signal numérique peut être généré sous la forme d'un signal « peigne » dont le spectre est composé de raies de fréquence kFs/N (où Fs est la fréquence d'échantillonnage et N le nombre de canaux du système de conversion analogique numérique à entrelacement temporel (CAN 10)) et l'amplitude fonction de la réponse fréquentielle du convertisseur analogique numérique. Notamment, ce signal peut être obtenu par modulation des signaux « peignes » de fréquence kFs/N en fonction de la réponse fréquentielle, par exemple à l'aide des informations de calibration IC. Ces signaux ont un spectre identique à celui des erreurs d'appariement comme le montre la figure 8.

Dans l'exemple de la figure 4, le signal d'entrée analogique $E_A$ est converti par le système de conversion analogique numérique CAN 10 suivant l'horloge d'échantillonnage $H_e$. L'horloge d'échantillonnage $H_e$ pilote des moyens de génération d'un signal de type peigne 11.

La génération de signaux de type « peigne » à partir de l'horloge d'échantillonnage peut comporter la création de signaux numériques correspondant aux raies du type $C_i = \frac{1}{N} \sum_{k=0}^{N-1} \Delta C_{ik} e^{-j2\pi\frac{l}{N}k}$ qui peuvent s'écrire sous la forme suivante, s'agissant de signaux réels :

$$C_i(n) = \frac{1}{N}\sum_{l=0}^{N-1}\sum_{k=0}^{N-1}\Delta C_{ik}e^{j2\pi\frac{l}{N}(n-k)}$$

$$= \sum_{l=0}^{N-1}\left[\left(\frac{1}{N}\sum_{k=0}^{N-1}\Delta C_{ik}\cos 2\pi\frac{l}{N}k\right)\cos 2\pi\frac{l}{N}n + \left(\frac{1}{N}\sum_{k=0}^{N-1}\Delta C_{ik}\sin 2\pi\frac{l}{N}k\right)\sin 2\pi\frac{l}{N}n\right]$$

$$= \sum_{l=0}^{N-1}\alpha_{il}\cos 2\pi\frac{l}{N}n + \beta_{il}\sin 2\pi\frac{l}{N}n$$

Ce signal possède un spectre composé de raies $kF_s/N$ comme l'illustre la figure 6. Les coefficients $\alpha_{il}$ et $\beta_{il}$ peuvent être obtenus lors de la phase de calibration comme le montre la figure 5. La figure 7 donne un exemple de mise en oeuvre du calcul de $C_i$, les valeurs $C_i(n)$ constituant alors les informations de calibration IC peuvent être mises en mémoire pour des valeurs de n comprises entre 0 et N-1. Cette mémoire adressée cycliquement par n (quelconque) permet, ensuite, de présenter en sortie les valeurs de $C_i$.

Un compteur 20 est synchronisé par un signal sync et piloté par l'horloge d'échantillonnage $H_e$. Ce compteur 20 permet la mise en mémoire cyclique des informations de calibration IC. Suivant les informations de calibration IC, elles sont respectivement mises dans la mémoire relative aux tensions de décalage 21, aux erreurs de gain 22, aux erreurs de phase 23 et aux erreurs de bande passante 24. Ces mémoires 21, 22, 23, 24 sont contrôlées en écriture par une commande CE et fournissent respectivement les valeurs $Vc_{os}(n)$, $C_g(n)$, $C_p(n)$ et $C_b(n)$.

Dans cet exemple, les valeurs $Vc_{os}(n)$, $C_g(n)$, $C_p(n)$ et $C_b(n)$ sont calculées en préalable à la modulation du signal d'entrée échantillonné lors de la phase de calibration du système de conversion analogique numérique à entrelacement temporel, et maintenues en mémoire pour utilisation comme information de calibration par les moyens de modulation d'amplitude dans la phase opérationnelle du système de conversion analogique numérique à entrelacement temporel.

Les moyens de modulation d'amplitude 12 reçoivent le signal peigne obtenu et opèrent sa modulation par le signal échantillonné $e(nT_s)$ en utilisant des informations de calibration IC, comme l'indique la figure 4.

Ce signal peut être modulé par le signal d'entrée ou les informations extraites du signal échantillonné (dérivée, filtrage passe haut). Ainsi sont obtenus des signaux représentatifs des erreurs de gain $Vc_g(n)$ et/ou des erreurs de phase $Vc_p(n)$ et/ou des erreurs de bande passante $Vc_b(n)$ par le produit des informations de calibration IC adéquates : i.e. du coefficient respectif $C_g$, $C_p$ ou $C_b$ avec respectivement le signal d'entrée $e(nT_s)$ , une approximation s'(n) de sa dérivée $de/dt(nT_s)$ ou du résultat $e_2(n)$ du filtrage passe haut du signal d'entrée.

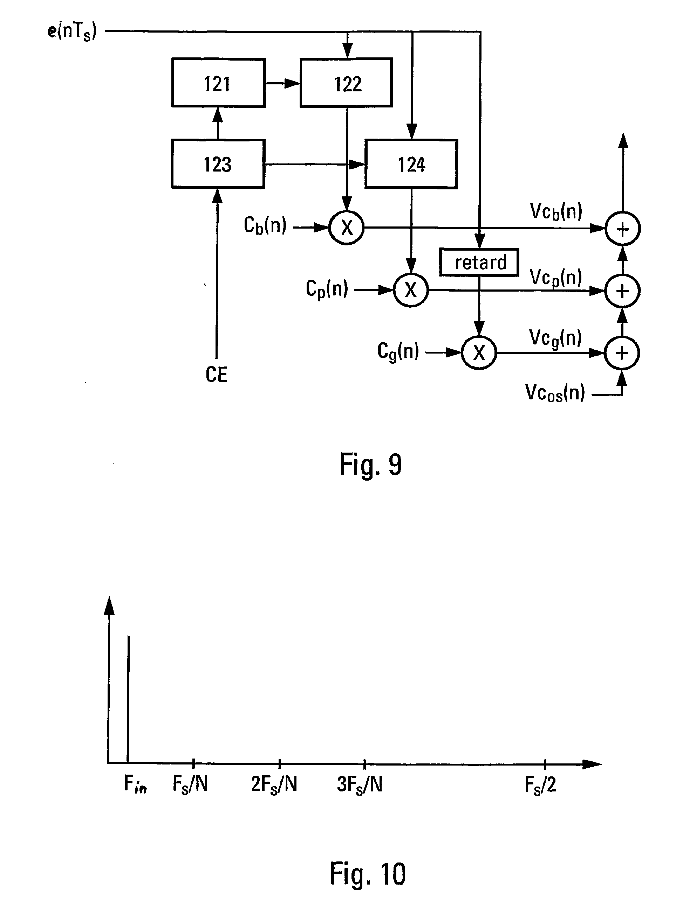

La figure 9 montre un exemple de réalisation des moyens de modulation 12. Les mémoires 121 et 123 fournissent respectivement les coefficients nécessaires à l'élaboration du filtre passe haut H 122 et du filtre de dérivation 124. Le signal numérique échantillonné $e(nT_s)$ en sortie du convertisseur analogique numérique est soit :

- directement multiplié par l'information de calibration IC correspondante au coefficient $C_g$ pour obtenir un signal représentatif des erreurs de gain $Vc_g(n)$ ;
- filtré par le filtre de dérivation 124 puis multiplié par l'information de calibration IC correspondant au coefficient $C_p$ pour obtenir un signal représentatif des erreurs de phase Vcp(n) ;
- filtré par le filtre H 122 puis multiplié par l'information de calibration IC correspondante au coefficient $C_b$ pour obtenir un signal représentatif des erreurs de bande passante $Vc_b(n)$.

L'ensemble de ces signaux représentatifs d'erreurs d'appariement $Vc_{os}(n)$, $Vc_g(n)$, $Vc_p(n)$ et $Vc_b(n)$ sont additionnés pour fournir le signal numérique représentatif des erreurs d'appariement (toutes causes confondues).

Le signal numérique représentatif des erreurs d'appariement est ensuite soustrait au signal numérisé grâce à un additionneur 13 (voir figure 4).

Ce type de système de conversion analogique numérique à entrelacement temporel avec correction des erreurs d'appariement présente un intérêt en terme de vitesse de conversion dans diverses applications. Les applications principales concernent les systèmes d'instrumentation et les systèmes de réception numérique, notamment :

- les systèmes d'instrumentation et de test, les oscilloscopes numériques ;
- les récepteurs numériques, notamment pour radar et guerre électronique ;
- les récepteurs à conversion directe, notamment lors de la démodulation RF et dans le cadre de la radio logicielle.

**Revendications**

1. Procédé de génération d'un signal numérique représentatif de l'erreur d'appariement entre les canaux d'un système de conversion analogique numérique à entrelacement temporel (CAN 10) comportant un convertisseur analogique numérique ($GAN_1$, $CAN_2$,...,$CAN_N$) sur chaque canal ;

   le procédé comportant la détermination du spectre dudit signal numérique (11-12) en fonction de la réponse fréquentielle du système de conversion analogique numérique à entrelacement temporel (CAN 10) à au moins un signal de calibration analogique (IC) ;

   le procédé étant **caractérisé en ce qu'**il comporte la génération dudit signal numérique sous la forme d'un signal « peigne » dont le spectre est composé de raies de fréquence $kF_s/N$ (11), où $F_s$ est la fréquence d'échantillonnage et N le nombre de canaux du système de conversion analogique numérique à entrelacement temporel (CAN 10), et dont l'amplitude (12) est fonction de la réponse fréquentielle du système de conversion analogique numérique.

2. Procédé de génération d'un signal numérique représentatif de l'erreur d'appariement selon la revendication précédente **caractérisé en ce que** l'amplitude est fonction des tensions de décalage $\Delta V_k$ (21) déterminées à partir de la réponse fréquentielle du système de conversion analogique numérique.

3. Procédé de génération d'un signal numérique représentatif de l'erreur d'appariement selon l'une des revendications 1 ou 2 **caractérisé en ce qu'**il comporte la modulation d'amplitude du signal « peigne » (12) par le signal d'entrée ($E_A$) numérisé par le système de conversion (CAN 10) de sorte que la modulation transforme le spectre du signal « peigne » en fonction de la réponse fréquentielle du système de conversion analogique numérique.

4. Procédé de génération d'un signal numérique représentatif de l'erreur d'appariement selon la revendication précédente **caractérisé en ce que** l'amplitude est fonction des écarts de gain $\Delta G_k$ (22) déterminés à partir de la réponse fréquentielle du système de conversion analogique numérique.

5. Procédé de génération d'un signal numérique représentatif de l'erreur d'appariement selon l'une des revendications précédentes **caractérisé en ce qu'**il comporte la modulation d'amplitude du signal « peigne » par la dérivée s'(n) du signal d'entrée numérisé par le système de conversion de sorte que la modulation (12) transforme le spectre du signal « peigne » en fonction de la réponse fréquentielle du système de conversion analogique numérique.

6. Procédé de génération d'un signal numérique représentatif de l'erreur d'appariement selon la revendication précédente **caractérisé en ce que** l'amplitude est fonction des écarts temporels $\Delta t_k$ (23) de l'horloge d'échantillonnage déterminés à partir de la réponse fréquentielle du système de conversion analogique numérique.

7. Procédé de génération d'un signal numérique représentatif de l'erreur d'appariement selon l'une des revendications précédentes **caractérisé en ce qu'**il comporte la modulation d'amplitude (12) du signal « peigne » par le résultat $e_2(n)$ du filtrage passe haut du signal d'entrée numérisé par le système de conversion de sorte que la modulation transforme le spectre du signal « peigne » en fonction de la réponse fréquentielle du système de conversion analogique numérique.

8. Procédé de génération d'un signal numérique représentatif de l'erreur d'appariement selon la revendication précédente **caractérisé en ce que** l'amplitude est fonction des erreurs de bande passante $\Delta \omega_k$ (24) déterminées à partir de la réponse fréquentielle du système de conversion analogique numérique.

9. Dispositif de conversion analogique numérique à entrelacement temporel de fréquence d'échantillonnage $F_s$ comportant :

   - un système (CAN10) comprenant N convertisseurs analogique numérique ($CAN_1$, $CAN_2$,...,$CAN_N$) pilotés par une horloge d'échantillonnage de fréquence $F_s/N$;
   - des moyens de génération d'un signal numérique représentatif de l'erreur d'appariement (11-12), signal généré par un procédé selon l'une quelconque des revendications 1 à 8 piloté par l'horloge ($H_e$) de fréquence $F_s$ ;
   - des moyens de soustraction (13) au signal de sortie dudit système de conversion analogique numérique du signal numérique généré par lesdits moyens de génération ;

   le dispositif étant **caractérisé en ce qu'**il comporte :

   - un dispositif de génération d'un signal « peigne » (11) piloté par l'horloge ($H_e$) de fréquence $F_s$ ;

- un dispositif de modulation d'amplitude (12) connecté à la sortie dudit dispositif de génération d'un signal « peigne » (11) recevant des informations de calibration (IC) déterminées en fonction de ladite réponse fréquentielle.

**Claims**

1. Method for generating a digital signal representative of the pairing error between the channels of an analogue to digital conversion system with time interleaving (10) comprising an analogue to digital converter ($CAN_1$, $CAN_2$,..., $CAN_N$) on each channel; the method comprising the determination of the spectrum of said digital signal (11-12) as a function of the frequency response of the analogue to digital conversion system with time interleaving (CAN 10) to at least one analogue calibration signal (IC); the method being **characterized in that** it comprises the generation of said digital signal in the form of a "comb" signal whose spectrum is composed of frequency lines kFs/N (11), where Fs is the sampling frequency and N the number of channels of the analogue to digital conversion system with time interleaving (CAN 10) and whose amplitude (12) is dependent on the frequency response of the analogue to digital conversion system.

2. Method for generating a digital signal representative of the pairing error according to the preceding claim, **characterized in that** the amplitude is dependent on the offset voltages $\Delta V_k$ (21) determined on the basis of the frequency response of the analogue to digital conversion system.

3. Method for generating a digital signal representative of the pairing error according to either of Claims 1 or 2, **characterized in that** it comprises the amplitude modulation of the "comb" signal (12) by the input signal ($E_A$) digitized by the conversion system (CAN 10) so that the modulation transforms the spectrum of the "comb" signal as a function of the frequency response of the analogue to digital conversion system.

4. Method for generating a digital signal representative of the pairing error according to the preceding claim **characterized in that** the amplitude is dependent on the deviations in gain $\Delta G_k$ (22) determined on the basis of the frequency response of the analogue to digital conversion system.

5. Method for generating a digital signal representative of the pairing error according to one of the preceding claims, **characterized in that** it comprises the amplitude modulation of the "comb" signal by the derivative s'(n) of the input signal digitized by the conversion system so that the modulation (12) transforms the spectrum of the "comb" signal as a function of the frequency response of the analogue to digital conversion system.

6. Method for generating a digital signal representative of the pairing error according to the preceding claim, **characterized in that** the amplitude is dependent on the sampling clock temporal deviations $\Delta t_k$ (23) determined on the basis of the frequency response of the analogue to digital conversion system.

7. Method for generating a digital signal representative of the pairing error according to one of the preceding claims, **characterized in that** it comprises the amplitude modulation (12) of the "comb" signal by the result $e_2$(n) of the high-pass filtering of the input signal digitized by the conversion system so that the modulation transforms the spectrum of the "comb" signal as a function of the frequency response of the analogue to digital conversion system.

8. Method for generating a digital signal representative of the pairing error according to the preceding claim, **characterized in that** the amplitude is dependent on the bandwidth errors $\Delta\omega_k$ (24) determined on the basis of the frequency response of the analogue to digital conversion system.

9. Analogue to digital conversion device with time interleaving of sampling frequency Fs comprising

- a system (CAN 10) comprising N analogue to digital converters ($CAN_1$, $CAN_2$,...,$CAN_N$) driven by a sampling clock of frequency Fs/N
- means for generating a digital signal representative of the pairing error (11-12), which signal is generated by a method according to any one of Claims 1 to 8 driven by the clock ($H_e$) of frequency Fs;
- means of subtraction (13) from the output signal of said analogue to digital conversion system of the digital signal generated by said generation means;
the device being **characterized in that** it comprises:
- a device for generating a "comb" signal (11) driven by the clock ($H_e$) of frequency Fs;

- an amplitude modulation device (12) connected to the output of said device for generating a "comb" signal (11) receiving calibration information (IC) determined as a function of said frequency response.

**Patentansprüche**

1. Verfahren zur Erzeugung eines digitalen Signals, das für den Anpassungsfehler zwischen den Kanälen eines Analog/Digital-Umwandlungssystems mit Zeitverschachtelung (CAN 10) repräsentativ ist, das in jedem Kanal einen Analog/Digital-Wandler ($CAN_1$, $CAN_2$, ..., $CAN_N$) aufweist;
   wobei das Verfahren die Bestimmung des Spektrums des digitalen Signals (11-12) in Abhängigkeit von der Frequenzantwort des Analog/Digital-Umwandlungssystems mit Zeitverschachtelung (CAN10) auf mindestens ein analoges Kalibrierungssignal (IC) aufweist;
   wobei das Verfahren **dadurch gekennzeichnet ist, dass** es die Erzeugung des digitalen Signals in Form eines "Kamm"-Signals aufweist, dessen Spektrum aus Frequenzlinien kFs/N (11) besteht, wobei Fs die Tastfrequenz und N die Anzahl von Kanälen des Analog/Digital-Umwandlungssystems mit Zeitverschachtelung (CAN 10) ist, und dessen Amplitude (12) von der Frequenzantwort des Analog/Digital-Umwandlungssystems abhängt.

2. Verfahren zur Erzeugung eines für den Anpassungsfehler repräsentativen digitalen Signals nach dem vorhergehenden Anspruch, **dadurch gekennzeichnet, dass** die Amplitude von den Offsetspannungen $\Delta V_k$ (21) abhängt, die ausgehend von der Frequenzantwort des Analog/Digital-Umwandlungssystems bestimmt werden.

3. Verfahren zur Erzeugung eines für den Anpassungsfehler repräsentativen digitalen Signals nach einem der Ansprüche 1 oder 2, **dadurch gekennzeichnet, dass** es die Amplitudenmodulation des "Kamm"-Signals (12) durch das vom Umwandlungssystem (CAN 10) digitalisierte Eingangssignal ($E_A$) aufweist, damit die Modulation das Spektrum des "Kamm"-Signals in Abhängigkeit von der Frequenzantwort des Analog/Digital-Umwandlungssystems umwandelt.

4. Verfahren zur Erzeugung eines für den Anpassungsfehler repräsentativen digitalen Signals nach dem vorhergehenden Anspruch, **dadurch gekennzeichnet, dass** die Amplitude von den Verstärkungsabweichungen $\Delta G_k$ (22) abhängt, die ausgehend von der Frequenzantwort des Analog/Digital-Systems bestimmt werden.

5. Verfahren zur Erzeugung eines für den Anpassungsfehler repräsentativen digitalen Signals nach einem der vorhergehenden Ansprüche, **dadurch gekennzeichnet, dass** es die Amplitudenmodulation des "Kamm"-Signals durch die Ableitung s'(n) des vom Umwandlungssystem digitalisierten Eingangssignals aufweist, damit die Modulation (12) das Spektrum des "Kamm"-Signals in Abhängigkeit von der Frequenzantwort des Analog/Digital-Umwandlungssystems umwandelt.

6. Verfahren zur Erzeugung eines für den Anpassungsfehler repräsentativen digitalen Signals nach dem vorhergehenden Anspruch, **dadurch gekennzeichnet, dass** die Amplitude von den Zeitabweichungen $\Delta t_k$ (23) des Abtasttaktgebers abhängt, die ausgehend von der Frequenzantwort des Analog/Digital-Umwandlungssystems bestimmt werden.

7. Verfahren zur Erzeugung eines für den Anpassungsfehler repräsentativen digitalen Signals nach einem der vorhergehenden Ansprüche, **dadurch gekennzeichnet, dass** es die Amplitudenmodulation (12) des "Kamm"-Signals durch das Ergebnis $e_2(n)$ der Hochpassfilterung des vom Umwandlungssystem digitalisierten Eingangssignals aufweist, damit die Modulation das Spektrum des "Kamm"-Signals in Abhängigkeit von der Frequenzantwort des Analog/Digital-Umwandlungssystems umwandelt.

8. Verfahren zur Erzeugung eines für den Anpassungsfehler repräsentativen digitalen Signals nach dem vorhergehenden Anspruch, **dadurch gekennzeichnet, dass** die Amplitude von den Bandbreitenfehlern $\Delta \omega_k$ (24) abhängt, die ausgehend von der Frequenzantwort des Analog/Digital-Umwandlungssystems bestimmt werden.

9. Analog/Digital-Umwandlungsvorrichtung mit Zeitverschachtelung einer Tastfrequenz Fs, die aufweist:

   - ein System (CAN 10) mit N Analog/Digital-Wandlern ($CAN_1$, $CAN_2$, ..., $CAN_N$), die von einem Frequenz-Abtasttaktgeber Fs/N gesteuert werden;
   - Mittel zur Erzeugung eines für den Anpassungsfehler repräsentativen Signals (11-12), das durch ein Verfahren nach einem der Ansprüche 1 bis 8 erzeugt wird, gesteuert von dem Taktgeber ($H_e$) der Frequenz Fs;

- Mittel (13) zum Subtrahieren des von den Erzeugungsmitteln erzeugten digitalen Signals vom Ausgangssignal des Analog/Digital-Umwandlungssystems;

wobei die Vorrichtung **dadurch gekennzeichnet ist, dass** sie aufweist:

- eine Vorrichtung zur Erzeugung eines "Kamm"-Signals (11), die von dem Taktgeber ($H_e$) der Frequenz Fs gesteuert wird;
- eine mit dem Ausgang der Vorrichtung zur Erzeugung eines "Kamm"-Signals (11) verbundene Vorrichtung zur Amplitudenmodulation (12), die Kalibrierungsinformationen (IC) empfängt, die in Abhängigkeit von der Frequenzantwort bestimmt werden.

Fig. 1

Fig. 2

Fig. 3

**Fig. 4**

**Fig. 5**

Fig. 6

Fig. 7

Fig. 8

$e(nT_s)$

| 121 | → | 122 |

| 123 |

| 124 |

CE

$C_b(n)$ → (X) → $Vc_b(n)$ → (+)

retard

$C_p(n)$ → (X) → $Vc_p(n)$ → (+)

$C_g(n)$ → (X) → $Vc_g(n)$ → (+)

$Vc_{os}(n)$

Fig. 9

$F_{in}$  $F_S/N$  $2F_S/N$  $3F_S/N$  $F_S/2$

Fig. 10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4633226 A
- US 4763105 A
- US 5239299 A

**Littérature non-brevet citée dans la description**

- **HUMMEL D.M.** Distortion compensation for time-interleaved analog to digital converters. *IEEE*